(19) Europäisches Patentamt / European Patent Office / Office européen des brevets

(11) **EP 3 115 799 B1**

(12) **FASCICULE DE BREVET EUROPEEN**

(45) Date de publication et mention
de la délivrance du brevet:
**23.08.2017   Bulletin 2017/34**

(51) Int Cl.:
***G01R 33/26*** *(2006.01)*

(21) Numéro de dépôt: **16178106.7**

(22) Date de dépôt: **06.07.2016**

(54) **MAGNÉTOMÈTRE TOUT OPTIQUE ET ISOTROPE**

OPTISCH-ISOTROPES MAGNETOMETER

ISOTROPIC AND ALL-OPTICAL MAGNETOMETER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **08.07.2015   FR 1556485**

(43) Date de publication de la demande:
**11.01.2017   Bulletin 2017/02**

(73) Titulaire: **Commissariat à l'Energie Atomique et
aux Energies
Alternatives
75015 Paris (FR)**

(72) Inventeurs:
• **MORALES, Sophie
  38760 VARCES (FR)**
• **BAICRY, Mathieu
  38360 SASSENAGE (FR)**
• **BERTRAND, François
  38180 SEYSSINS (FR)**
• **LE PRADO, Matthieu
  38160 SAINT-MARCELLIN (FR)**
• **LEGER, Jean-Michel
  38190 VILLARD BONNOT (FR)**
• **ROSSINI, Umberto
  38500 COUBLEVIE (FR)**
• **RUTKOWSKI, Jaroslaw
  50-555 Wroclaw (PL)**

(74) Mandataire: **Brevalex
  56, Boulevard de l'Embouchure
  B.P. 27519
  31075 Toulouse Cedex 2 (FR)**

(56) Documents cités:
FR-A1- 2 984 519

• **J. RUTKOWSKI ET AL: "Towards a miniature
  atomic scalar magnetometer using a liquid
  crystal polarization rotator", SENSORS AND
  ACTUATORS A., vol. 216, 13 mai 2014
  (2014-05-13), pages 386-393, XP055272789, CH
  ISSN: 0924-4247, DOI: 10.1016/j.sna.2014.05.003**
• **GAWLIK W ET AL: "Nonlinear magneto-optical
  rotation with amplitude modulated light",
  APPLIED PHYSICS LETTERS, A I P PUBLISHING
  LLC, US, vol. 88, no. 13, 29 mars 2006
  (2006-03-29) , pages 131108-131108,
  XP012080785, ISSN: 0003-6951, DOI:
  10.1063/1.2190457**
• **CASSIMI A ET AL: "4HE OPTICAL PUMPING WITH
  INTENSITY MODULATED LASER LIGHT",
  JOURNAL DE PHYSIQUE 2 FRANCE,, vol. 1, no.
  2, 1 février 1991 (1991-02-01) , pages 123-133,
  XP009054650, ISSN: 1155-4312, DOI:
  10.1051/JP2:1991151**
• **ZHANG J-H ET AL: "Realization and Optimization
  of all-optical Cs atom magnetometer based on
  Bell-Bloom structure", GUANGDIANZI-JIGUANG
  - JOURNAL OF OPTRONICS-LASER, TIANJIN
  DAXUE JIDIAN FENXIAO, TIANJIN, CN, vol. 26,
  no. 2, 15 février 2015 (2015-02-15), pages 211-216,
  XP008180255, ISSN: 1005-0086**
• **WU T ET AL: "A dead-zone free4He atomic
  magnetometer with intensity-modulated linearly
  polarized light and a liquid crystal polarization
  rotator", REVIEW OF SCIENTIFIC
  INSTRUMENTS, AIP, MELVILLE, NY, US, vol. 86,
  no. 10, 13 octobre 2015 (2015-10-13), pages
  103105-1-103105-6, XP012201279, ISSN:
  0034-6748, DOI: 10.1063/1.4932528 [extrait le
  1901-01-01]**

**Description**

**DOMAINE TECHNIQUE**

La présente invention concerne de manière générale le domaine des magnétomètres à pompage optique.

**ÉTAT DE LA TECHNIQUE ANTÉRIEURE**

Les magnétomètres à pompage optique sont connus depuis plusieurs décennies. Ils sont basés sur la résonance magnétique entre sous-niveaux Zeeman, amplifiée à l'aide d'un pompage optique. Par exemple dans un magnétomètre de ce type utilisant une cellule d'hélium ($^4$He) les atomes d'hélium au niveau $1^1S_0$ sont excités au niveau métastable $2^3S_1$ au moyen d'une décharge HF. Ce niveau métastable $2^3S_1$ est divisé en un triplet Zeeman en présence d'un champ magnétique statique. Les atomes du niveau $2^3S_1$ sont pompés optiquement vers le niveau $2^3P_0$ à l'aide d'un laser accordable. Il en résulte une déplétion différente des différents sous-niveaux du triplet, par excitation sélective au niveau $2^3P_0$. Les atomes ainsi excités retournent par émission spontanée au niveau métastable $2^3S_1$. On induit une résonance magnétique entre les niveaux du triplet au moyen d'un champ RF à la fréquence de Larmor. L'amplitude du signal de résonance est amplifiée par le pompage optique. La résonance est observée au moyen d'un pic d'absorption du faisceau laser en sortie de la cellule. En pratique, le générateur du champ RF est asservi en fréquence sur le pic d'absorption au moyen d'une boucle PLL, et le module du champ magnétique se déduit directement de la fréquence de résonance $F$ à partir de la relation de Larmor $B_0 = (2\pi/\gamma)F$ où $\gamma$ est le rapport gyromagnétique de l'électron. Un tel magnétomètre mesurant le module du champ magnétique est encore appelé magnétomètre scalaire dans la littérature.

En pratique, les magnétomètres à pompage optique sont fortement anisotropes. En effet, des extinctions du signal de mesure se produisent pour certaines orientations du capteur par rapport à la direction du champ magnétique à mesurer.

Différentes solutions ont été proposées pour remédier à cette anisotropie de mesure.

Le brevet EP-B-579537 au nom de la présente demanderesse décrit un magnétomètre à pompage optique comprenant une cellule emplie d'hélium, un laser émettant un faisceau à une longueur d'onde accordée à la différence d'énergie entre les niveaux $2^3P_0$ et $2^3S_1$ de $^4$He (raie D0), un polariseur pour polariser linéairement le faisceau avant qu'il soit injecté dans la cellule et un photodétecteur recevant le faisceau ayant traversé la cellule. Le magnétomètre comprend également un circuit de décharge faisant passer les atomes d'hélium du niveau fondamental $1^1S_0$ au niveau métastable $2^3S_1$ au moyen d'une décharge électrostatique entre deux électrodes placées sur la cellule. Enfin, un générateur de fréquence RF alimente en courant deux bobines d'axes orthogonaux entourant la cellule de manière à engendrer un champ magnétique RF au sein de cette dernière. Les axes des deux bobines et la direction de propagation du faisceau sont choisis de manière à former un trièdre rectangle.

Dans ce magnétomètre, on s'affranchit de l'anisotropie de mesure en asservissant, d'une part, la direction de polarisation du faisceau et, d'autre part, la direction du champ magnétique RF de manière à ce qu'elles soient toutes deux dans le plan orthogonal au champ magnétique à mesurer. L'asservissement de la direction de polarisation est réalisé au moyen d'une détection synchrone à la fréquence de Larmor.

Une première variante de ce magnétomètre a été décrite dans le brevet EP-B-656545 également au nom de la présente demanderesse. Selon cette variante, le polariseur rectiligne et les bobines RF sont rendus mécaniquement solidaires de sorte que la direction de polarisation est toujours parallèle à la direction du champ magnétique RF. L'ensemble constitué par le polariseur et les bobines RF est mis en rotation par un moteur amagnétique, l'asservissement en rotation étant assuré par une détection synchrone à la fréquence de Larmor.

Une seconde variante de ce magnétomètre a été décrite dans le brevet FR-B-2984519. Cette seconde variante présente l'avantage de ne nécessiter ni pièce tournante ni codeur de position angulaire, la direction de polarisation du faisceau de pompe étant asservie au moyen d'un rotateur de polarisation à cristaux liquides et celle du champ magnétique RF étant pilotée par les courants alimentant les bobines d'induction.

Bien qu'ayant suivi une évolution remarquable, les magnétomètres à pompage optique de l'art antérieur présentent encore toutefois certains inconvénients.

Tout d'abord, il est nécessaire de contrôler la direction du champ RF pour qu'il soit perpendiculaire au champ magnétique externe à mesurer. Le contrôle de la direction du champ requiert soit d'utiliser des systèmes mécaniques complexes avec codeur angulaire, soit d'effectuer des calculs supplémentaires pour obtenir les courants d'alimentation dans les bobines RF.

En outre, l'utilisation d'un champ RF pour observer la résonance complique considérablement la mise en réseau des magnétomètres, le champ RF généré par un magnétomètre pouvant perturber la mesure effectuée par un autre magnétomètre si ceux-ci sont proches l'un de l'autre (problème de diaphonie entre magnétomètres voisins).

Le but de la présente invention est par conséquent de proposer un magnétomètre à pompage optique ne présentant pas les inconvénients précités. En particulier, la présente invention vise à réaliser un magnétomètre à pompage optique, isotrope, simple et robuste, ne requérant pas de contrôle du champ RF et susceptible d'être mis en réseau.

## EXPOSÉ DE L'INVENTION

La présente invention est définie par un magnétomètre à pompage optique comprenant une cellule remplie d'un gaz, une source laser émettant un faisceau laser, un module de polarisation adapté à polariser rectilignement le faisceau laser et à en faire tourner la polarisation pour que le faisceau laser soit polarisé dans une direction de polarisation, un photodétecteur recevant le faisceau laser polarisé après qu'il a traversé la cellule et fournissant un signal électrique, des premiers moyens d'asservissement pour maintenir un angle constant entre la direction de polarisation et un champ magnétique à mesurer, ledit magnétomètre comprenant en outre des moyens de modulation pour moduler au moins une première partie du faisceau laser de manière à générer un faisceau pompe modulé au moyen d'une fréquence de modulation ($f_m$) et des seconds moyens d'asservissement pour maintenir ladite fréquence de modulation égale à la fréquence de Larmor du gaz ou l'une de ses harmoniques, les seconds moyens d'asservissement effectuent une détection d'amplitude sur le sommet de la raie DC, un signal d'erreur antisymétrique étant obtenu par une démodulation à une harmonique d'une seconde fréquence de modulation superposée à la fréquence de modulation, la valeur du champ magnétique à mesurer étant obtenue à partir de ladite fréquence de modulation.

Selon un premier mode de réalisation, les moyens de modulation effectuent une modulation en intensité à la fréquence de Larmor et au double de cette fréquence.

Dans une première variante, le photodétecteur reçoit le faisceau pompe et le signal électrique résultant de la conversion du faisceau pompe par le photodétecteur est fourni aux premiers et aux seconds moyens d'asservissement.

Dans une seconde variante, le magnétomètre comprend un séparateur optique en amont du module de polarisation pour former une première partie et une seconde partie du faisceau laser, le faisceau pompe ($P$) étant obtenu en modulant la première partie du faisceau laser par lesdits moyens de modulation, la seconde partie du faisceau laser formant un faisceau sonde ($S$), non modulé par lesdits moyens de modulation, le signal électrique résultant de la conversion du faisceau sonde étant fourni aux premiers et aux seconds moyens d'asservissement.

Selon une première configuration, le faisceau sonde et le faisceau pompe sont parallèles et séparés d'une distance inférieure à la longueur de diffusion des atomes de gaz dans la cellule.

Selon une seconde configuration, le faisceau sonde et le faisceau pompe se croisent dans la cellule selon un angle sensiblement inférieur à 90°, préférentiellement inférieur à 10° voire à 5°.

Les premiers moyens d'asservissement effectuent avantageusement une démodulation à la fréquence de Larmor.

Les moyens de modulation peuvent être constitués par un modulateur acousto-optique. Alternativement, ils peuvent être constitués par un modulateur électro-optique.

Lorsque la source laser une diode laser, le magnétomètre peut comprendre des troisièmes moyens d'asservissement recevant ledit signal électrique et contrôlant le courant d'alimentation et/ou la température de la diode laser de manière à ce que le faisceau laser ait une longueur d'onde constante.

Selon un second mode de réalisation, les moyens de modulation effectuent une modulation en fréquence à la fréquence de Larmor.

Les moyens de modulation comprennent par exemple un coupleur AC/DC pour superposer un courant de modulation au courant d'alimentation du laser.

Les premiers moyens d'asservissement effectuent avantageusement une démodulation à la fréquence de Larmor.

Lorsque la source laser est une diode laser, le magnétomètre peut comprendre des troisièmes moyens d'asservissement recevant ledit signal électrique et contrôlant le courant d'alimentation et/ou la température de manière à ce que la fréquence porteuse du faisceau laser soit constante.

## BRÈVE DESCRIPTION DES DESSINS

D'autres caractéristiques et avantages de l'invention apparaîtront à la lecture d'un mode de réalisation préférentiel de l'invention en référence aux figures jointes parmi lesquelles :

La Fig. 1 représente schématiquement un magnétomètre tout optique et isotrope, selon un premier mode de réalisation de l'invention ;
La Fig. 2 représente schématiquement un magnétomètre tout optique et isotrope, selon une variante du premier mode de réalisation ;
La Fig. 3 représente schématiquement un magnétomètre tout optique et isotrope, selon un second mode de réalisation de l'invention ;
La Fig. 4 représente un exemple de circuit de modulation de la longueur d'onde du laser dans la Fig. 3.

**EXPOSÉ DÉTAILLÉ DE MODES DE RÉALISATION PARTICULIERS**

Le principe de base de la présente invention est d'induire une résonance entre les sous-niveaux Zeeman de manière purement optique en lieu et place de la résonance induite par le champ RF dans l'art antérieur.

Selon un premier mode de réalisation de l'invention, la résonance est induite par une modulation d'intensité du faisceau pompe.

Selon un second mode de réalisation de l'invention, la résonance est induite par une modulation de la longueur d'onde du faisceau pompe.

Quel que soit le mode de réalisation, l'isotropie de la mesure est assurée en maintenant constant l'angle entre la direction de polarisation du faisceau de pompe et la direction du champ magnétique à mesurer.

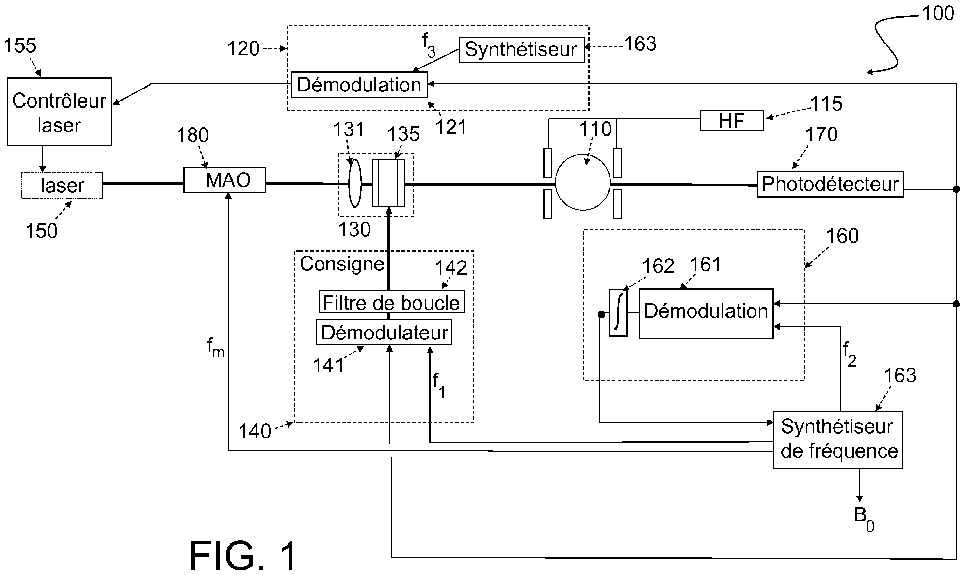

La Fig. 1 représente schématiquement un premier mode de réalisation d'un magnétomètre tout optique et isotrope selon un premier mode de réalisation de l'invention.

Ce magnétomètre, 100, comprend une cellule 110 remplie de gaz, par exemple de l'hélium ou un gaz alcalin. On choisira de préférence un gaz dont les atomes présentent un spin nucléaire nul (nombre pair de nucléons), la fréquence de Larmor étant alors directement proportionnelle au champ magnétique à mesurer. Pour des raisons de simplification de la présentation, et sans perte de généralité, nous supposerons dans la suite de la description que le gaz utilisé est $^4$He.

Un circuit de décharge HF, 115, permet de faire passer les atomes du niveau fondamental $1^1S_0$ au niveau métastable $2^3S_1$ au moyen d'une décharge haute fréquence entre deux électrodes placées de part et d'autre de la cellule. Le niveau métastable $2^3S_1$ se divise en un triplet Zeeman en présence du champ magnétique à mesurer, $\mathbf{B}_0$.

Un laser 150 émet un faisceau à une longueur d'onde accordée à la différence d'énergie entre les niveaux $2^3P_0$ et $2^3S_1$. Ce faisceau subit une modulation d'intensité au moyen par exemple d'un modulateur acousto-optique ou d'un modulateur électro-optique, 180.

L'intensité du faisceau ainsi modulé peut s'exprimer sous la forme :

$$I(t) = I_0(1 + \varepsilon \sin\left(2\pi f_m t\right)) \qquad\qquad (1)$$

où $I_0$ est l'intensité du faisceau laser non-modulé, $\varepsilon$ est la profondeur de modulation et $f_m$ est la fréquence de modulation.

Le faisceau ainsi modulé est ensuite polarisé au moyen d'un module de polarisation, 130, constitué d'un polariseur rectiligne, 131, et d'un rotateur de polarisation à cristaux liquides nématiques, 135. Alternativement, le module de polarisation peut comprendre un polariseur rectiligne monté sur un support orientable commandé en rotation par un moteur amagnétique, par exemple un moteur piézoélectrique. Quel que soit le mode de réalisation du module de polarisation, celui-ci permet d'orienter la polarisation du faisceau dans une direction quelconque orthogonalement à sa direction de propagation de façon à maintenir constant l'angle entre la direction de polarisation du faisceau pompe et la direction du champ magnétique et ceci quelle que soit l'orientation du capteur.

Le faisceau laser permet de réaliser un pompage optique du niveau métastable $2^3S_1$ au niveau excité $2^3P_0$. La modulation d'intensité du faisceau est réalisée à une fréquence $f_m$ égale à la fréquence de Larmor $f_m = f_L = \dfrac{\omega_L}{2\pi} = \dfrac{\gamma}{2\pi} B_0$ ou à une harmonique de cette fréquence (par exemple $f_m = f_L / 2$ ou $f_m = 2f_L$). La modulation d'intensité du faisceau laser à la fréquence de Larmor (ou à une harmonique de cette fréquence) permet d'induire une résonance entre les sous-niveaux Zeeman du niveau métastable.

Après avoir interagi avec le gaz de la cellule, le faisceau laser est converti en un signal électrique par un photodétecteur, 170.

La résonance est mise en évidence au moyen d'un premier module de démodulation, 140, permettant d'asservir la direction de polarisation du faisceau laser perpendiculairement au champ magnétique $\mathbf{B}_0$, et d'un second module de démodulation, 160, permettant d'asservir la fréquence de modulation de l'intensité optique du faisceau laser.

Le premier module de démodulation, 140, reçoit le signal issu du photodétecteur, 170, et effectue une démodulation à une première fréquence de référence $f_1$ fournie par le synthétiseur de fréquence, 163. Le démodulateur 141 est avantageusement suivi d'un filtre de boucle 142 en charge de contrôler l'asservissement. Le signal démodulé par le démodulateur 141 sert de signal d'erreur pour asservir la direction de polarisation sur une direction de consigne faisant un angle $\theta$ constant avec la direction du champ magnétique $\mathbf{B}_0$. On choisira de préférence $\theta = 90°$. Le signal d'erreur est d'amplitude nulle lorsque la direction de polarisation est alignée sur la direction de consigne et symétrique en fonction de la fréquence de modulation $f_m$.

Le second module de démodulation reçoit le signal issu du photodétecteur 170 et effectue une démodulation à une seconde fréquence de référence $f_2$, fournie par le synthétiseur de fréquence 163, pour générer un signal de mesure. Le démodulateur 161 est avantageusement suivi d'un filtre de boucle 162 (typiquement un filtre passe-bas tel qu'un intégrateur). Ce signal de mesure est un signal antisymétrique en fonction de la fréquence de modulation $f_m$.

Le résultat de la seconde démodulation/intégration est une valeur de consigne permettant de piloter la génération de la fréquence de modulation $f_m$ par le synthétiseur de fréquence 163. La valeur de consigne est proportionnelle à la fréquence de Larmor et peut être convertie pour fournir la valeur du champ magnétique. L'intensité du champ magnétique $B_0$ peut être obtenue à partir de la consigne de fréquence du synthétiseur de fréquence 163 lorsque celui-ci est implémenté en numérique.

Un exemple de point de fonctionnement d'un magnétomètre tout optique isotrope modulé en intensité est décrit ci-après (correspondant à $\theta=90°$).

Le signal envoyé au modulateur acousto-optique (ou électro-optique) 180 est ici la somme d'une modulation à $\omega_L$ et à $2\omega_L$ de telle sorte que l'intensité du faisceau optique modulé peut s'écrire sous la forme :

$$I(t) = I_0 \left[ 1 + \varepsilon_1 \cos\left(2\pi f_L t\right) + \varepsilon_2 \cos\left(4\pi f_L t\right) \right] \qquad (2)$$

Pour le contrôle de la direction de polarisation (module 140), la démodulation consiste en une détection synchrone entre le signal issu du photodétecteur et le signal de référence à la fréquence $f_1$. Le signal d'intérêt pour le module 140 est le signal de résonance à la fréquence de Larmor de telle sorte que $f_1 = f_L$.

Pour la mesure du champ $B_0$ et l'asservissement de la fréquence de modulation $f_m$ (module 160), l'asservissement est effectué sur le sommet de la raie de résonance DC et une RF basse fréquence $f_{mod\_BF}$ (typ. 1kHz, de profondeur de modulation voisine de la largeur à mi-hauteur de la raie) est superposée à la fréquence de modulation $f_m$. Le modulateur acousto-optique effectue un modulation à $f_m[1 + A\cos(2\pi.f_{modBF}.t)]$. La modulation basse fréquence à $f_{mod\_BF}$ induit une modulation d'amplitude: une détection d'amplitude permet de disposer d'un signal qui s'annule et change de signe à la résonance. Le signal d'asservissement antisymétrique qui s'annule à la résonance est obtenu par une détection synchrone effectuée à une harmonique de la fréquence $f_{mod\_BF} \approx 1kHz$ : $f_2$ est donc égal à $f_{mod\_BF}$ ou à une harmonique de $f_{mod\_BF}$.

Optionnellement, le magnétomètre pourra être équipé d'un troisième module de démodulation, 120, permettant d'accorder la longueur d'onde du faisceau laser pompe sur la raie D0. Pour cela, la longueur d'onde du laser est modulée à des fréquences qui n'induisent pas de résonance, par exemple $f_{mod\_laser} \approx 10$ *kHz*. Plusieurs types de modulation en longueur d'onde peuvent être envisagés: modulation directe du courant d'alimentation de la diode laser ou actuateur piézoélectrique ou modulateur de longueur d'onde (ou phase) électro-optique ou acousto-optique. Ce troisième module de démodulation 120 reçoit, d'une part, le signal issu du photodétecteur 170 et, d'autre part, un troisième signal de référence à la fréquence $f_3 = f_{mod\_laser}$ issu du synthétiseur de fréquence 163 (le synthétiseur de fréquence a été dupliqué sur la figure pour des raisons de représentations). Le résultat de cette démodulation permet de contrôler le courant d'alimentation et/ou la température de la diode laser, 150, au moyen d'un contrôleur de longueur d'onde, 155, de manière à maintenir constante la longueur d'onde du laser.

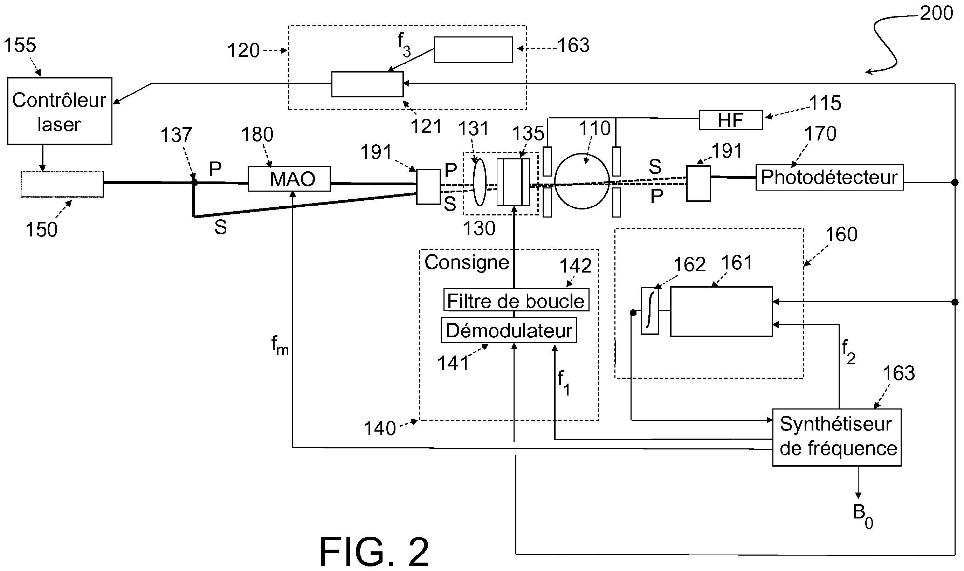

La Fig. 2 représente schématiquement un magnétomètre tout optique et isotrope, selon une variante du premier mode de réalisation.

Les éléments identiques à ceux représentés en Fig. 1 portent les mêmes signes de référence.

A la différence de la variante précédente, le magnétomètre 200 dissocie les fonctions de pompage optique et de mesure de la résonance.

Plus précisément, le faisceau émis par le laser 150 est d'abord divisé par un coupleur optique, 137, en un faisceau pompe P et un faisceau sonde *S*.

Le faisceau pompe P est modulé par le modulateur d'intensité 180 avant d'être injecté dans la cellule 110. Comme dans la variante précédente, la modulation d'intensité du faisceau pompe induit une résonance entre les sous-niveaux Zeeman.

Le faisceau sonde permet de détecter la résonance induite par le faisceau pompe.

Le faisceau pompe P en sortie du modulateur d'intensité 180 ainsi que le faisceau sonde S sont dirigés vers le polariseur rectiligne 131 et le rotateur de polarisation 135 au moyen de fibres optiques et de collimateurs optiques 191. Le couple constitué par le polariseur rectiligne 131 et le rotateur de polarisation peut être remplacé par un polariseur rectiligne monté sur un support orientable et entraîné en rotation par un moteur amagnétique.

Selon un premier exemple de réalisation, le faisceau sonde traverse la zone pompée par le faisceau pompe. Plus précisément, on choisit alors un faible angle de croisement (de préférence compris entre 0° et 40° et par exemple inférieur à 10° voire à 5°) entre les faisceaux pompe et sonde de manière à maximiser le recouvrement des deux faisceaux.

Selon un second exemple de réalisation (non illustré), les faisceaux pompe et sonde sont choisis parallèles et séparés par une distance inférieure à la longueur de diffusion des atomes (dépendant de la pression de gaz dans la cellule et du temps de relaxation des atomes).

Quel que soit l'exemple de réalisation, après avoir interagi avec le gaz de la cellule, le faisceau sonde est converti en signal électrique au moyen du photodétecteur 170. Comme dans le mode de réalisation de la Fig. 1, le signal issu du photodétecteur peut être soumis à une première démodulation, en 140, pour contrôler la direction de polarisation du polariseur et une seconde démodulation, 160, pour piloter la fréquence de modulation en intensité du faisceau pompe. Optionnellement, une troisième démodulation, 120, peut être prévue pour contrôler en fonction du mode de réalisation choisi le courant d'alimentation et/ou la température de la diode laser, de manière à maintenir constante la longueur d'onde du laser.

La variante de réalisation illustrée en Fig. 2 est avantageuse dans la mesure où les démodulations sont effectuées à partir du faisceau sonde et non du faisceau pompe modulé. Cette technique permet de découpler la modulation de la mesure du signal de résonance. La détection de la résonance en est par conséquent facilitée.

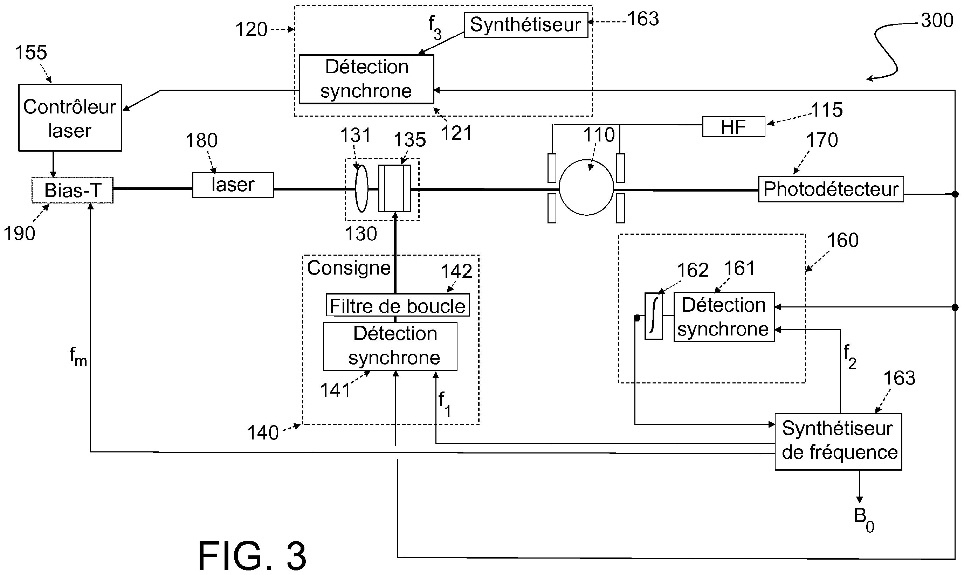

La Fig. 3 représente schématiquement un magnétomètre tout optique et isotrope, selon un second mode de réalisation de l'invention.

Dans ce mode de réalisation, la résonance est induite par une modulation de la longueur d'onde du faisceau pompe. Plus précisément, la fréquence du faisceau de pompe est modulée selon :

$$ \nu(t) = \nu_0 + \Delta \nu_a + \frac{\Delta \nu_m}{2} \cos\left(2\pi f_m t\right) \tag{3} $$

où $v_0$ est la fréquence centrale de la raie d'absorption utilisée pour le pompage optique (correspondant à la fréquence de transition entre les niveaux $2^3S_1$ et $2^3P_0$), $\Delta v_a$ est le décalage entre la fréquence porteuse et la fréquence centrale de la raie d'absorption, $\Delta v_m$ est la profondeur de modulation et $f_m$ est la fréquence de modulation en fréquence. On choisira avantageusement la fréquence de modulation égale à la fréquence de Larmor, soit $f_m = f_L$ ou à l'une de ses harmoniques (par exemple $f_m = f_L / 2$ ou $f_m = 2f_L$).

Les éléments portant les mêmes signes de référence qu'en Fig. 1 ou 2, sont identiques à ceux déjà décrits. A la différence du premier mode de réalisation, le magnétomètre 300 ne comprend pas de modulateur d'intensité 180 (acousto-optique ou électro-optique). La diode laser 150 est alimentée via un coupleur AC/DC, 190, permettant de moduler le courant d'alimentation autour d'un point de fonctionnement donné.

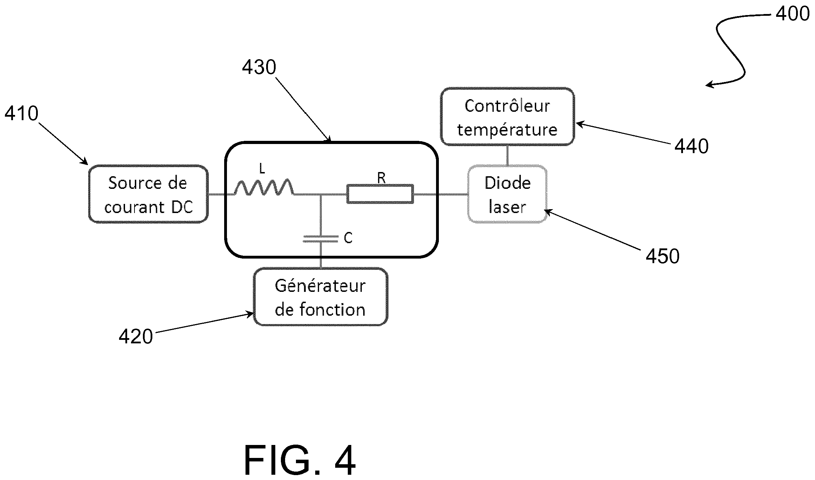

La Fig. 4 représente un exemple de circuit d'alimentation d'une diode laser, 450. Ce circuit comprend une source d'alimentation en courant DC, 410, un générateur de courant, 420, générant un courant AC ayant une fonction temporelle déterminée, un circuit RLC, 430, faisant office de coupleur AC/DC (bias-T), un contrôleur de température 440 et ladite diode laser 450. Le courant appliqué à la diode laser n'est autre que la somme du courant DC fourni par la source 410 et du courant AC fourni par le générateur 420. La modulation du courant traversant la diode laser induit une modulation de la longueur d'onde de cette dernière. Ainsi, dans le second mode de réalisation, il n'est pas besoin de prévoir un modulateur externe.

Comme dans le premier mode de réalisation, le magnétomètre comprend un premier module de démodulation, 140, pour effectuer une démodulation du signal issu du photodétecteur à une première fréquence de référence $f_1$. Cette démodulation permet d'asservir la direction de polarisation du faisceau laser, par le rotateur de polarisation 135, de manière à ce qu'il présente un angle constant (de préférence $\theta=90°$) avec le champ magnétique à mesurer. Comme précédemment, le couple constitué par le polariseur rectiligne 131 et le rotateur de polarisation 135 peut être remplacé par un polariseur rectiligne monté sur un support orientable et pouvant être entrainé en rotation par un moteur amagnétique.

Le magnétomètre comprend également un second module de démodulation, 160, pour effectuer une démodulation du signal issu du photodétecteur à une seconde fréquence de référence $f_2$. Cette démodulation permet d'asservir la fréquence de modulation du faisceau laser $f_m$ de manière à créer une résonance entre les sous-niveaux Zeeman. Avantageusement, on asservira la fréquence de modulation à la fréquence de Larmor, soit $f_m = f_L$ et l'on choisira un asservissement de la direction de polarisation par détection synchrone à $f_1 = f_L$ (plus spécifiquement, le signal d'erreur pour asservir la direction de polarisation du faisceau laser est le signal de résonance en quadrature détecté à la fréquence de Larmor. Ce signal est symétrique en fonction de la fréquence de modulation, s'annule pour l'angle $\theta = 90°$ et est antisymétrique autours de $\theta = 90°$). En outre, le signal de mesure et d'asservissement de la fréquence de modulation est celui obtenu par détection synchrone à $f_2 = 2 * f_{mod\_BF} \approx 2\ kHz$. Le signal de résonance est le signal continu sur lequel on rajoute une modulation basse fréquence à $f_{mod\_BF}$. Une détection d'amplitude permet d'obtenir un signal d'erreur. Le signal antisymétrique qui permet d'asservir la fréquence de modulation est le signal de résonance sur l'harmonique 2 de $f_{mod\_BF}$.

De manière optionnelle, on pourra prévoir, comme précédemment, un troisième module de démodulation, 120, pour asservir la longueur d'onde de la diode laser, via le contrôleur laser 155, de manière à ce que la fréquence porteuse $v_0 + \Delta v_a$ soit maintenue à une valeur constante. Pour cela, une modulation complémentaire à $f_3 = f_{mod\_laser} \approx 10\ kHz$ pourra être superposée aux modulations précédentes.

**Revendications**

1. Magnétomètre à pompage optique comprenant une cellule remplie d'un gaz (110), une source laser (150) émettant un faisceau laser, un module de polarisation (130) adapté à polariser rectilignement le faisceau laser et à en faire tourner la polarisation pour que le faisceau laser soit polarisé dans une direction de polarisation, un photodétecteur (170) recevant le faisceau laser polarisé après qu'il a traversé la cellule et fournissant un signal électrique, des premiers moyens d'asservissement (140) pour maintenir un angle constant entre la direction de polarisation et un champ magnétique à mesurer, **caractérisé en ce qu'**il comprend en outre des moyens de modulation (180, 190) pour moduler en intensité ou en fréquence au moins une première partie du faisceau laser de manière à générer un faisceau pompe modulé au moyen d'une fréquence de modulation ($f_m$) et des seconds moyens d'asservissement (160) pour maintenir ladite fréquence de modulation égale à la fréquence de Larmor du gaz ou l'une de ses harmoniques, les seconds moyens d'asservissement (160) effectuent une détection d'amplitude sur le sommet de la raie DC, un signal d'erreur antisymétrique étant obtenu par une démodulation à une harmonique d'une seconde fréquence de modulation ($f_{mod\_BF}$) superposée à la fréquence de modulation ($f_m$), la valeur du champ magnétique à mesurer étant obtenue à partir de ladite fréquence de modulation.

2. Magnétomètre à pompage optique selon la revendication 1, **caractérisé en ce que** les moyens de modulation (180) effectuent une modulation en intensité à la fréquence de Larmor et au double de cette fréquence.

3. Magnétomètre à pompage optique selon la revendication 2, **caractérisé en ce que** le photodétecteur (170) reçoit le faisceau pompe et que le signal électrique résultant de la conversion du faisceau pompe par le photodétecteur est fourni aux premiers et aux seconds moyens d'asservissement (140,160).

4. Magnétomètre à pompage optique selon la revendication 2, **caractérisé en ce qu'**il comprend un séparateur optique (137) en amont du module de polarisation (130) pour former une première partie et une seconde partie du faisceau laser, le faisceau pompe (P) étant obtenu en modulant la première partie du faisceau laser par lesdits moyens de modulation, la seconde partie du faisceau laser formant un faisceau sonde (S), non modulé par lesdits moyens de modulation, le signal électrique résultant de la conversion du faisceau sonde étant fourni aux premiers et aux seconds moyens d'asservissement (140,160).

5. Magnétomètre à pompage optique selon la revendication 4, **caractérisé en ce que** le faisceau sonde et le faisceau pompe sont parallèles et séparés d'une distance inférieure à la longueur de diffusion des atomes de gaz dans la cellule.

6. Magnétomètre à pompage optique selon la revendication 4, **caractérisé en ce que** le faisceau sonde et le faisceau pompe se croisent dans la cellule selon un angle sensiblement inférieur à 90°, préférentiellement inférieur à 10° voire à 5°.

7. Magnétomètre à pompage optique selon l'une des revendications précédentes, **caractérisé en ce que** les premiers moyens d'asservissement (140) effectuent une démodulation à la fréquence de Larmor.

8. Magnétomètre à pompage optique selon l'une des revendications 2 à 7, **caractérisé en ce que** les moyens de modulation sont constitués par un modulateur acousto-optique.

9. Magnétomètre à pompage optique selon l'une des revendications 2 à 7, **caractérisé en ce que** les moyens de modulation sont constitués par un modulateur électro-optique.

10. Magnétomètre à pompage optique selon l'une des revendications précédentes, **caractérisé en ce que** la source laser est une diode laser et qu'il comprend des troisièmes moyens d'asservissement (120) recevant ledit signal électrique et contrôlant le courant d'alimentation et/ou la température de la diode laser de manière à ce que le faisceau laser ait une longueur d'onde constante.

11. Magnétomètre à pompage optique selon la revendication 1, **caractérisé en ce que** les moyens de modulation effectuent une modulation en fréquence à la fréquence de Larmor.

12. Magnétomètre à pompage optique selon la revendication 11, **caractérisé en ce que** les moyens de modulation comprennent un coupleur AC/DC (190) pour superposer un courant de modulation au courant d'alimentation du laser.

**13.** Magnétomètre à pompage optique selon l'une des revendications 11 ou 12, **caractérisé en ce que** les premiers moyens d'asservissement (140) effectuent une démodulation à la fréquence de Larmor.

**14.** Magnétomètre à pompage optique selon l'une des revendications 11 à 13, **caractérisé en ce que** la source laser est une diode laser et qu'il comprend des troisièmes moyens d'asservissement (120) recevant ledit signal électrique et contrôlant le courant d'alimentation et/ou la température de manière à ce que la fréquence porteuse du faisceau laser soit constante.

**Patentansprüche**

**1.** Magnetometer mit optischem Pumpen, umfassend eine gasgefüllte Zelle (110), eine Laserquelle (150), die einen Laserstrahl emittiert, ein Polarisationsmodul (130), das dazu ausgelegt ist, den Laserstrahl linear zu polarisieren und seine Polarisation zu drehen, damit der Laserstrahl in einer Polarisationsrichtung polarisiert ist, einen Fotodetektor (170), der den polarisierten Laserstrahl empfängt, nachdem er die Zelle durchquert hat, und der ein elektrisches Signal liefert, erste Steuermittel (140), um einen Winkel zwischen der Polarisationsrichtung und einem zu messenden Magnetfeld konstant zu halten, **dadurch gekennzeichnet, dass** es ferner Modulationsmittel (180, 190) umfasst, um wenigstens einen ersten Teil des Laserstrahls in der Intensität oder in der Frequenz derart zu modulieren, dass ein Pumpstrahl erzeugt wird, der mittels einer Modulationsfrequenz ($f_m$) moduliert ist, sowie zweite Steuermittel (160), um die Modulationsfrequenz gleich der Larmorfrequenz des Gases oder einer ihrer Harmonischen zu halten, wobei die zweiten Steuermittel (160) eine Amplitudenerfassung auf der Spitze der DC-Linie durchführen, wobei ein antisymmetrisches Fehlersignal erhalten wird durch eine Demodulation bei einer Harmonischen einer zweiten Modulationsfrequenz ($f_{mod\_BF}$), die der Modulationsfrequenz ($f_m$) überlagert ist, wobei der Wert des zu messenden Magnetfelds ausgehend von der Modulationsfrequenz erhalten wird.

**2.** Magnetometer mit optischem Pumpen nach Anspruch 1, **dadurch gekennzeichnet, dass** die Modulationsmittel (180) eine Intensitätsmodulation bei der Larmorfrequenz und beim Doppelten dieser Frequenz durchführen.

**3.** Magnetometer mit optischem Pumpen nach Anspruch 2, **dadurch gekennzeichnet, dass** der Fotodetektor (170) den Pumpstrahl empfängt, und dass das elektrische Signal, welches aus der Konversion des Pumpstrahls durch den Fotodetektor resultiert, an die ersten und die zweiten Steuermittel (140, 160) geliefert wird.

**4.** Magnetometer mit optischem Pumpen nach Anspruch 2, **dadurch gekennzeichnet, dass** es stromaufwärts des Polarisationsmoduls (130) einen optischen Separator (137) umfasst, um einen ersten Teil und einen zweiten Teil des Laserstrahls zu bilden, wobei der Pumpstrahl (P) erhalten wird durch Modulieren des ersten Teils des Laserstrahls durch die Modulationsmittel, wobei der zweite Teil des Laserstrahls einen durch die Modulationsmittel nicht modulierten Sondenstrahl (S) bildet, wobei das elektrische Signal aus der Konversion des Sondenstrahls resultiert, der an die ersten und die zweiten Steuermittel (140, 160) geliefert wird.

**5.** Magnetometer mit optischem Pumpen nach Anspruch 4, **dadurch gekennzeichnet, dass** der Sondenstrahl und der Pumpstrahl parallel und um einen Abstand separiert sind, der kleiner ist als die Diffusionslänge der Atome des Gases in der Zelle.

**6.** Magnetometer mit optischem Pumpen nach Anspruch 4, **dadurch gekennzeichnet, dass** der Sondenstrahl und der Pumpstrahl sich in der Zelle unter einem Winkel schneiden, der wesentlich kleiner als 90° ist, vorzugsweise kleiner als 10° oder sogar als 5°.

**7.** Magnetometer mit optischem Pumpen nach einem der vorhergehenden Ansprüche, **dadurch gekennzeichnet, dass** die ersten Steuermittel (140) eine Demodulation bei der Larmorfrequenz durchführen.

**8.** Magnetometer mit optischem Pumpen nach einem der Ansprüche 2 bis 7, **dadurch gekennzeichnet, dass** die Modulationsmittel durch einen akkusto-optischen Modulator gebildet sind.

**9.** Magnetometer mit optischem Pumpen nach einem der Ansprüche 2 bis 7, **dadurch gekennzeichnet, dass** die Modulationsmittel durch einen elektro-optischen Modulator gebildet sind.

**10.** Magnetometer mit optischem Pumpen nach einem der vorhergehenden Ansprüche, **dadurch gekennzeichnet, dass** die Laserquelle eine Laserdiode ist, und dass es dritte Steuermittel (120) umfasst, die das elektrische Signal empfangen und den Versorgungsstrom und/oder die Temperatur der Laserdiode derart steuern, dass der Laserstrahl eine konstante Wellenlänge hat.

11. Magnetometer mit optischem Pumpen nach Anspruch 1, **dadurch gekennzeichnet, dass** die Modulationsmittel eine Frequenzmodulation bei der Larmorfrequenz durchführen.

12. Magnetometer mit optischem Pumpen nach Anspruch 11, **dadurch gekennzeichnet, dass** die Modulationsmittel einen AC/DC-Koppler (190) umfassen, um dem Versorgungsstrom des Lasers einen Modulationsstrom zu überlagern.

13. Magnetometer mit optischem Pumpen nach einem der Ansprüche 11 oder 12, **dadurch gekennzeichnet, dass** die ersten Steuermittel (140) eine Demodulation bei der Larmorfrequenz durchführen.

14. Magnetometer mit optischem Pumpen nach einem der Ansprüche 11 bis 13, **dadurch gekennzeichnet, dass** die Laserquelle eine Laserdiode ist, und dass es dritte Steuermittel (120) umfasst, die das elektrische Signal empfangen und den Versorgungsstrom und/oder die Temperatur derart steuern, dass die Trägerfrequenz des Laserstrahls konstant ist.

## Claims

1. Optical pumping magnetometer comprising a cell filled with a gas (110), a laser source (150) emitting a laser beam, a polarisation module (130) adapted to linearly polarise the laser beam and to rotate the polarisation such that the laser beam is polarised in a polarisation direction, a photodetector (170) receiving the polarised laser beam after it has passed through the cell and outputting an electrical signal, first slaving means (140) to keep a constant angle between the polarisation direction and a magnetic field to be measured, **characterised in that** it also includes modulation means (180,190) to intensity or frequency modulate at least a first part of the laser beam so as to generate a pump beam modulated by a modulation frequency ($f_m$) and second slaving means (160) to keep said modulation frequency equal to the Larmor frequency of the gas or one of its harmonics, the second slaving means (160) performing an amplitude detection on the peak of the DC line, the antisymmetric error signal being obtained by demodulation at a harmonic of a second modulation frequency ($f_{mod\_BF}$) superposed on the modulation frequency ($f_m$) the value of the magnetic field to be measured being obtained from said modulation frequency.

2. Optical pumping magnetometer according to claim 1, **characterised in that** the modulation means (180) make an intensity modulation at the Larmor frequency and at twice this frequency.

3. Optical pumping magnetometer according to claim 2, **characterised in that** the photodetector (170) receives the pump beam and **in that** the electrical signal resulting from conversion of the pump beam by the photodetector is output to the first and second slaving means (140, 160).

4. Optical pumping magnetometer according to claim 2, **characterised in that** the magnetometer comprises an optical separator (137) on the input side of the polarisation module (130) to form a first part and a second part of the laser beam, the pump beam (*P*) being obtained by modulating the first part of the laser beam by said modulation means, the second part of the laser beam forming a probe beam (S) not modulated by said modulation means, the electrical signal resulting from conversion of the probe beam being input to the first and to the second slaving means (140, 160).

5. Optical pumping magnetometer according to claim 4, **characterised in that** the probe beam and the pump beam are parallel and are separated by a distance less than the diffusion length of gas atoms in the cell.

6. Optical pumping magnetometer according to claim 4, **characterised in that** the probe beam and the pump beam intersect in the cell at an angle of significantly less than 90°, and preferably less than 10° or even 5°.

7. Optical pumping magnetometer according to one of the above claims, **characterised in that** the first slaving means (140) perform a demodulation at the Larmor frequency.

8. Optical pumping magnetometer according to one of claims 2 to 7, **characterised in that** the modulation means are composed of an acousto-optic modulator.

9.  Optical pumping magnetometer according to one of the claims 2 to 7, **characterised in that** the modulation means are composed of an electro-optic modulator.

10. Optical pumping magnetometer according to one of the above claims, **characterised in that** the laser source is a laser diode and that it comprises third slaving means (120) receiving said electrical signal and controlling the power supply current and/or the temperature of the laser diode such that the wavelength of the laser beam is constant.

11. Optical pumping magnetometer according to claim 1, **characterised in that** the modulation means make a frequency modulation at the Larmor frequency.

12. Optical pumping magnetometer according to claim 11, **characterised in that** the modulation means comprise an AC/DC coupler (190) to superpose a modulation current on the laser power supply current.

13. Optical pumping magnetometer according to one of claims 11 or 12, **characterised in that** the first slaving means (140) perform a demodulation at the Larmor frequency.

14. Optical pumping magnetometer according to one of claims 11 to 13, **characterised in that** the laser source is a laser diode and that it comprises third slaving means (120) receiving said electrical signal and controlling the power supply current and/or the temperature such that the laser beam carrier frequency is constant.

FIG. 1

FIG. 2

FIG. 3

FIG. 4

EP 3 115 799 B1

## RÉFÉRENCES CITÉES DANS LA DESCRIPTION

**Documents brevets cités dans la description**

- EP 579537 B
- EP 656545 B
- FR 2984519 B